# EUROPEAN PATENT APPLICATION

(11) **EP 1 246 326 A1**
(43) Date of publication of application: **02.10.2002**
(21) Application number: 01303100.0
(22) Date of filing: 30.03.2001
(51) Int. Cl.: H01S 5/022

(54) **Electronic packages**

(71) Applicant: Agilent Technologies, Inc. (a Delaware corporation), Palo Alto, CA 94303 (US)
(72) Inventor: Rookes, Christian, Ipswich, Suffolk IP4 4DE (GB)
(74) Representative: Coker, David Graeme

(57) **Abstract**

A high frequency electronic package (500) having a metal housing (504) and a high frequency electronic component, such as a laser diode, contained within the metal housing (504). One or more leads (508, 510, 512, 514) pass into the metal housing through a header (506) and are coupled to the high frequency electronic component. The leads, metal housing and components within the housing cause stray inductances and capacitances, which cause problems in matching and driving the high frequency electronic component. Therefore a high value capacitor (502) is coupled between the metal housing and an anode lead, as close to the anode as possible, to short the stray capacitances at high frequencies. The capacitor can be a ring capacitor positioned over the anode lead externally of the housing, or can be a plate capacitor mounted internally or externally of the housing.

## Description

### Field of the Invention

This invention relates, in general, to electronic packages and more particularly to electronic packages having high frequency electronic devices, such as those used in telecommunications applications, especially, for high speed optical communications.

### Background of the Invention

Electronic devices, especially high power semiconductor devices, such as laser diodes, are often housed within so called "Transistor Outline (TO)-Cans", which are metallic, generally cylindrically shaped housings in which the laser diode and other components are mounted and coupled appropriately to leads supplying data signals, as well as power. The TO-Can housings are generally designed to be used with devices operating at signal frequencies less than one gigahertz (GHz). However, due to the versatility and widespread use of the TO-Can housing, they are frequently also used for in digital, radio frequency (RF), microwave, and millimetre-wave applications in excess of 1GHz.

This can lead to problems caused by the parasitic effects of stray capacitance and inductance found within the structure of the TO-Can housing and its contents, such as problems with matching and driving the electronic devices contained within the housing. An example of this is a TO-Can housing containing a laser diode mounted on a metal heat sink, with data and power leads leading to the diode entering the housing via insulating seals. In this example, the leads into and out of the housing behave like inductors, whilst there also exists a capacitance between the leads, the insulating seals and the metal housing body. Any internal bond wires also provide inductance, the metal heat sink, together with its insulating substrate, exhibits capacitance that can be as high as a picofarad and the laser diode itself can exhibit both resistance and capacitance. Thus, the TO-Can housing and its contents can be considered as a complex LCR circuit having several resonant points in frequency when used over frequency ranges spanning several GHz. If the TO-Can metal body is grounded, then it is possible by modelling to deduce the effective electrical impedance of the device over the frequencies of interest. However, grounding a TO-Can housing has the undesirable effect of causing it to act like a filter and hence reducing the useable bandwidth of the device. Conversely, if a TO-Can housing is not well grounded, then the impedance becomes much more difficult to determine and has a greater variation over a given frequency range. This is because the parasitic elements of the TO-Can housing are able to resonate.

Furthermore, in some cases, the TO-Can housing cannot be grounded to the signal ground because it is generally externally connected to a chassis ground plane (to reduce electromagnetic emissions) instead of a signal ground. However, the chassis grounding only takes place when the device is mounted, so that the impedance of the TO-Can laser diode device associated with the connection to the chassis ground plane varies depending upon the specific application of the device and cannot easily be compensated for in advance.

Therefore, it is desirable to remove, or at least reduce, the parasitic effects of stray capacitance and inductance in a housing for a high frequency electronic device without electrically grounding the housing.

### Brief Summary of the Invention

Accordingly, in a first aspect, the present invention provides a high frequency electronic package comprising a metal housing, at least one high frequency electronic device contained within the metal housing, at least one lead passing into the metal housing and coupled to the at least one high frequency electronic device, and a capacitance device coupled between the metal housing and the at least one lead for shorting stray capacitances to the at least one lead at high frequencies.

According to a second aspect of the present invention, there is provided a high frequency fibre optic transceiver incorporating the high frequency electronic package described above.

### Brief Description of the Drawings

Exemplary embodiments of the present invention will now be described with reference to the accompanying drawings, of which:
FIG. 1 is an illustration of a prior art laser diode TO-Can package;
FIG. 2 is an electrical model of the prior art laser diode TO-Can package of FIG. 1;
FIG. 3 is an electrical model of a laser diode TO-Can package embodying the present invention;
FIG. 4 is an illustration of a TO-Can package constituting a first embodiment of the present invention;
FIG. 5 is an illustration of a TO-Can package constituting a second embodiment of the present invention;
FIG. 6 is an illustration of a TO-Can package constituting a third embodiment of the present invention; and
FIG. 7 is an illustration of a fibre optic transceiver utilising the TO-Can package of any of FIGS. 4 to 6.

### Detailed Description of the Drawings

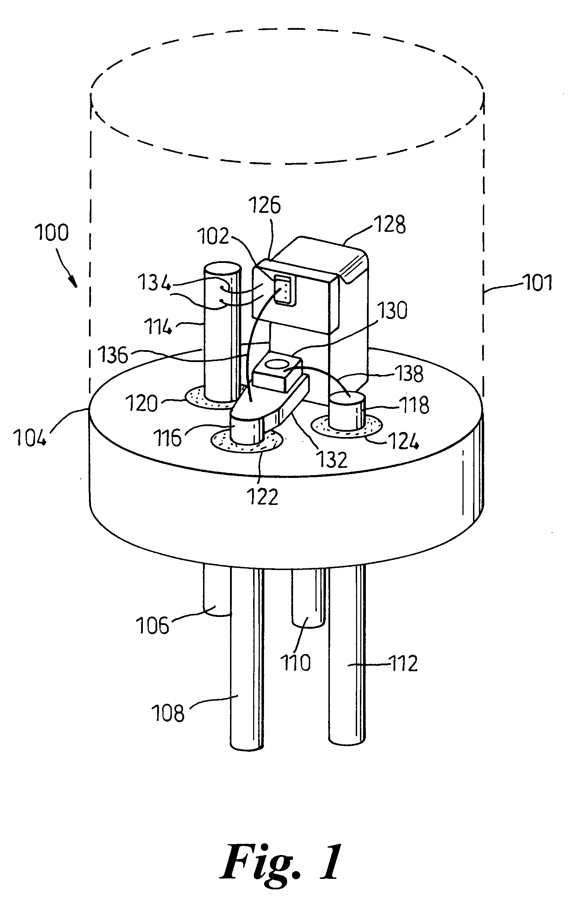

Thus, FIG. 1 shows a known electronic package 100 having a laser diode 102 mounted in a TO-Can housing 101, with further components (not shown) being housed in other parts of the housing 101. The To-Can housing 101 is generally cylindrical and incorporates a TO-Can header 104 having four pins 106, 108, 110, 112 passing through the central part of the header 104 to an internal portion of the TO-Can housing 101 for connection to the electrical components therewithin. Each of the four pins 106, 108, 110, 112 is held in position by a glass seal 120, 122, 124 (the glass seal for laser heat sink pin 110 is not illustrated) surrounding each pin where it passes through the TO-Can header 104. A cathode pin 106 terminates in the form of a cathode 114 on an internal surface of the TO-Can header 104, an anode pin 108 terminates in the form of an anode 116 on the internal surface of the TO-Can header 104, and a photodiode pin 112 terminates in the form of a photodiode terminal 118 on the internal surface of the TO-Can header 104. A laser heat sink pin 110 terminates in the form of a laser heatsink block 128 on the internal surface of the TO-Can header 104.

The laser heatsink block 128 has a metal laser heatsink 126 attached to a surface thereof and a laser diode 102 is located on a surface of the laser heatsink 126. The anode 116 of anode pin 108 terminates in a metal tab 132, which extends below the metal laser heatsink 126 and has a photodiode 130 positioned thereon. A pair of bond wires 134 couple the the laser heatsink 126 to the cathode 114, a bond wire 136 couples the laser diode 102 to the anode 116, and a further bond wire 138 couples the photodiode 130 to the photodiode terminal 118.

In operation, a high frequency input signal is applied to the cathode 114. A supply voltage is applied to the anode 116 and the anode 116 also functions as a bias for the photodiode 130. The photodiode 130, whilst not essential to the operation of the laser diode, functions to register the amount of light emitted from the laser diode 102. By means of a feedback loop, the photodiode 130 controls the light intensity emitted by the laser diode 102. The laser heatsink pin 110 is generally coupled to signal ground which acts to ground the TO-Can metal body. The four pins 106, 108, 110, 112 behave like inductors and there also exists a capacitance between the pins. The bond wires 134, 136, 138 are inductive and the laser heat sink 126 exhibits capacitance. The laser diode 102 generally exhibits both capacitance and resistance.

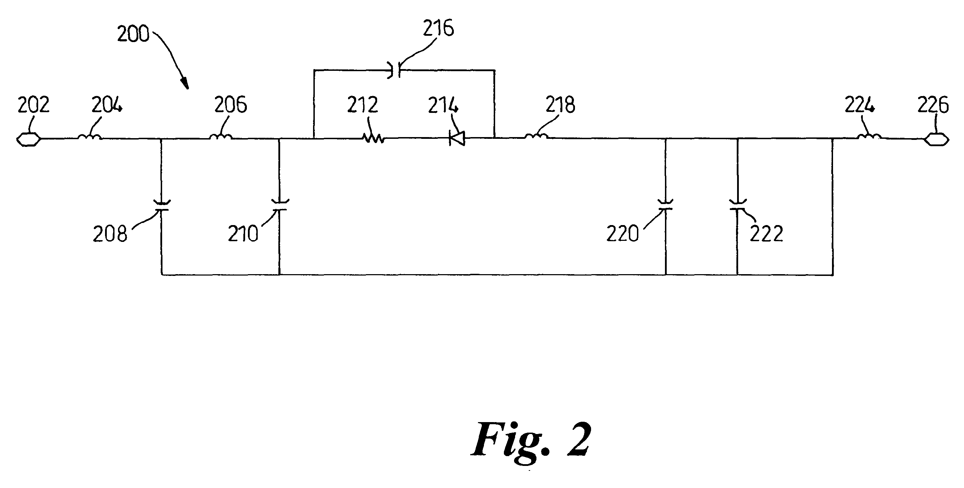

An electrical model 200 of the package of FIG. 1 is illustrated in FIG. 2. The cathode 202 has an associated inductance 204, which, in this example, is approximately 0.5nH (nanoHenrys). The two internal bond wires 134 coupling the cathode 202 to the laser diode have an inductance 206. (Whilst the inductance associated with a single internal bond wire is 1.0nH, the use of two internal bond wires serves to reduce the inductance to 0.7nH). The glass seal between the cathode 202 and the TO-Can header 104 has a capacitance 208 of approximately 0.4pF. In parallel with capacitance 208 is a capacitance 210 of the laser heat sink 126, which may be as high as a picofarad (pF). The laser diode 102 can be represented as a diode 214 and a resistance 212 ( of approximately 5 Ohms) coupled in series. A capacitance 216 associated with the laser diode (approximately 10pF) is coupled in parallel with the diode 214 and the resistance 212. An inductance 218 is associated with the internal bond wire 136 coupled between the laser diode 102 and the anode 116 and is approximately 1.0nH. The metal tab 132 has a capacitance 220 of approximately 0.1 pF and the glass seal 122 between the anode and the TO-Can header 104 has a capacitance 222 of approximately 0.4pF, which two capacitances are represented in parallel on FIG. 2. Finally, there is an inductance 224 (0.5nH) associated with the anode 202.

The electrical model clearly shows that stray capacitance is present at four nodes 208, 210, 220 and 222. The largest stray capacitance 210 occurs between the laser heatsink (onto which the laser diode is mounted) and the TO-Can header 104.

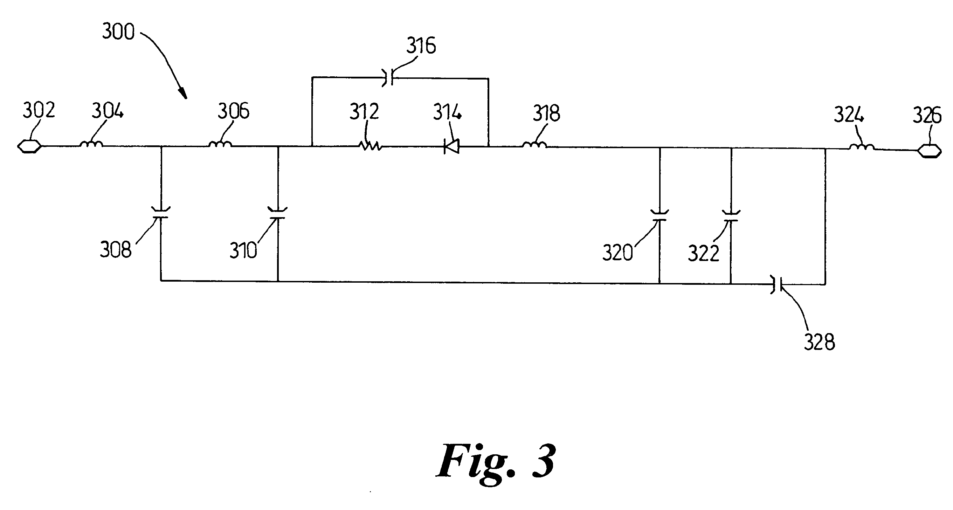

An electrical model of an embodiment of the present invention is illustrated in FIG. 3. In this case, the structure of the electrical model 300 is the same as that of the electrical model shown in FIG. 2, with identical features to those of FIG. 2 having the same reference numerals as those of FIG. 2, but with a "3" instead of a "2" at the beginning. Thus, for example, capacitance 208 in FIG. 2 is capacitance 308 in FIG. 3. In electrical model 300 an additional capacitor 328 of high value is coupled between the inductance 324 and the capacitance 308. The addition of the additional capacitor 328 close to the anode 326 causes the inductance 324 of the anode to be negated. Consequently, the stray capacitances 308, 310, 320 and 322 are shorted to the anode 326 at high frequencies and unwanted parasitic responses are avoided. For input frequencies in excess of 1 GHz, the minimum value of capacitor 328 in this embodiment of the present invention is approximately 100pF.

Advantageously, the parasitic effects of stray capacitance have thus been removed without electrically grounding the electronic device. Furthermore, the embodiment is of low cost to implement as only a single additional component is required. Several methods of implementation of the present invention are envisaged, as will be further described below.

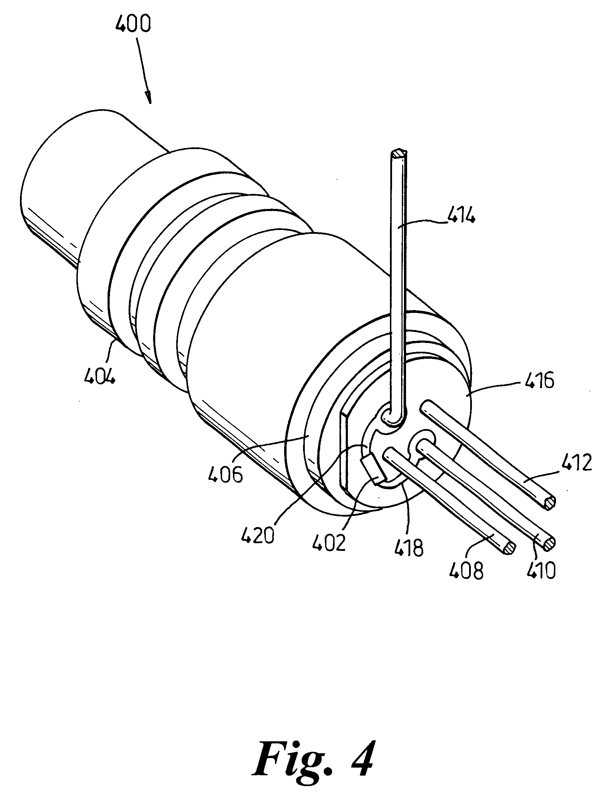

FIG. 4 illustrates a first implementation of the model described above with reference to FIG. 3. FIG. 4 shows a complete TO-Can housing 400 formed by a TO-Can body 404 fitted over a TO-Can header 406 and enclosing the contents of the TO-Can housing. Pins 408, 410, 412 and 414 project from the TO-Can header 406 through a Printed Circuit Board (PCB) 416 located on a face of the TO-Can header 406. The additional high value capacitor 402 is surface mounted on the PCB 416, between a pair of metallic tracks 418 and 420 printed on the PCB. The metallic tracks lead from the capacitor 420 to a respective one of the pins 410 and 414, so as to provide electrical connection between the capacitor and the respective pin. Thus, the capacitor 420 is coupled in series between pin 410 and pin 414. Pins 408 and 412 provide the cathode and photodiode connections, and pin 414 terminates on the internal side of the TO-Can header as the laser heatsink block, and can be used for mechanical support externally. In place of the PCB, a ceramic material substrate could be used.

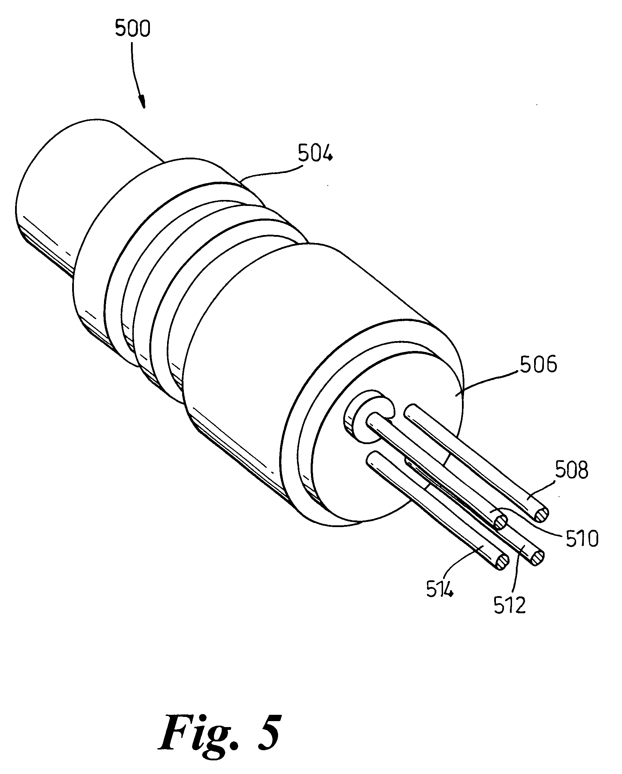

FIG. 5 illustrates a second implementation of the embodiment of the present invention in which a complete TO-Can package 500 formed by a TO-Can body 504 is fitted over a TO-Can header 506 and encloses the contents of the TO-Can device. Pins 508, 510, 512 and 514 project from the TO-Can header 506. The additional capacitor 502 is again part of the TO-Can electronic package 500. The additional capacitor 502 has a central hole (sometimes known as a "donut capacitor") enabling it to be located around the anode pin 510 projecting from the base of the TO-Can header 506 and in electrical contact therewith. , The additional capacitor 502 is also in electrical contact with the base of the TO-Can header 512 to provide the capacitive coupling between the anode pin and the TO-Can header. Although shown in a ring shape, it will be appreciated that the donut capacitor could have a square or rectangular outer shape.

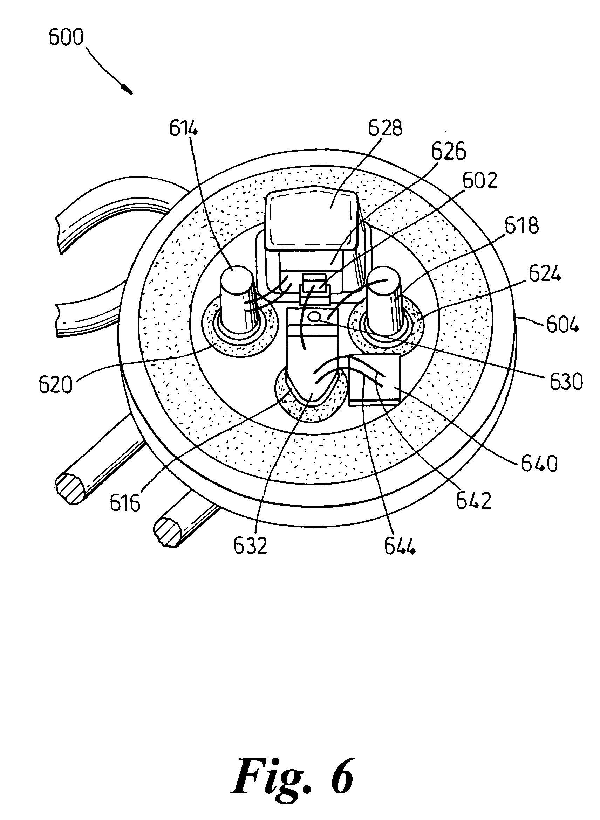

FIG. 6 illustrates a third implementation of the embodiment of the present invention in which a TO-Can header 604 and components mounted on the TO-Can header are the same as those illustrated and described with reference to FIG. 1, with the same elements having the same reference numerals as those of FIG. 1, but with a "6" instead of a "1" at the beginning. Thus, for example, the TO-Can header 604 in FIG. 6 is the same as TO-Can header 104 in FIG. 1. As shown, the cathode pin passes through the TO-Can header 604 via the glass seal 620 and terminates as a cathode 614, the anode pin passes through the TO-Can header 604 via the glass seal 620 and terminates in the form of an anode 616, and photodiode pin passes through the TO-Can header 604 via the glass seal 624 and terminates as photodiode terminal 618. The laser heat sink pin as a laser heatsink block 628 and has metal laser heatsink 626 attached thereto, with a laser diode 602 located on a surface of the laser heatsink 626. The anode 616 terminates as a metal tab 632, which extends below the metal laser heatsink 626 and has photodiode 630 positioned thereon. The additional capacitor 640 is located immediately adjacent the anode 616. Two internal bond wires 642 and 644 couple the anode 616 to the additional capacitor 640, which is also electrically coupled via its contact with the TO-Can header 604. Preferably, the additional capacitor 640 is a ceramic plate capacitor.

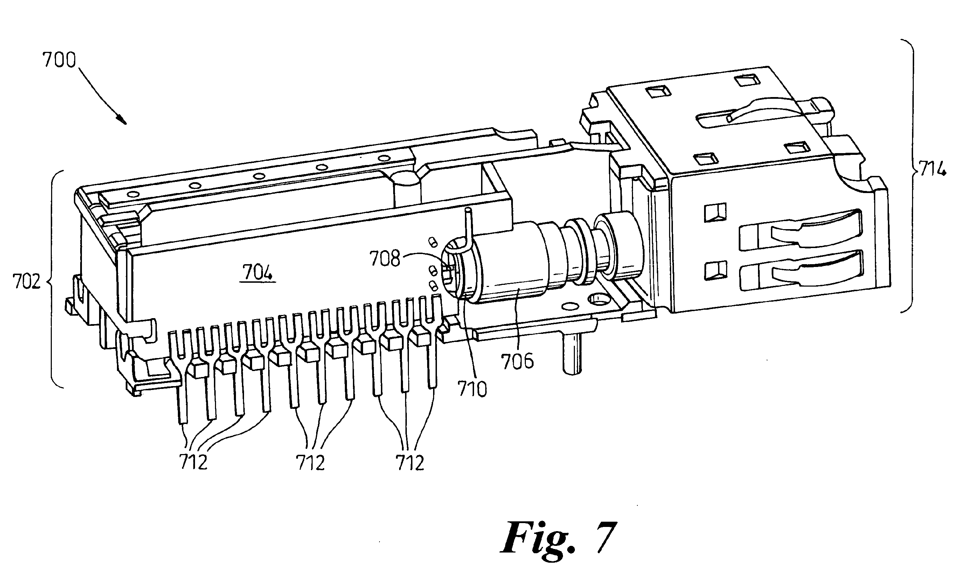

FIG. 7 illustrates a fibre optic transceiver 700 in which an embodiment of the present invention can advantageously be used, particularly showing a transmitter module of the transceiver. The fibre optic transceiver illustrated is part of a Lucent Connector Small Form Factor (LC SFF) platform manufactured by Agilent Technologies and is a 2.5GBit/s 1310nm Synchronous Optical NETwork / Synchronous Digital Hierarchy (SONET/SDH) fibre optic transceiver which is an industry standard in the telecommunications field. The terminology "Small Form Factor" refers to the external dimensions of the fibre optic transceiver and also the location of the pins protruding from the PCB 704 (ten pins 712 are illustrated in FIG. 7).

The transceiver includes a laser driver module 702 having a PCB 704 on which laser drive circuitry is mounted. A TO-Can package 706 containing laser diode components is positioned within the fibre optic transceiver 700 such that the pins from the TO-Can package connect to the laser drive circuitry on PCB 704. The TO-Can package 706 is similar to that illustrated in FIG. 4 and includes the additional capacitor 708 mounted on a PCB fixture 710 which is located on the header of the TO-Can package. A connector portion 714 of the transceiver is used to accurately position optical fibres coming from the TO-Can package 706 to a desired module.

In operation, the laser driver module 702 of the fibre optic transceiver 700 receives electrical signals from communications device (not shown). The electrical signals are processed by components within the fibre optic transceiver 700 and are used to drive the laser diode within the TO-Can package 706 to produce a light signal, which is coupled into optical fibres within the TO-Can package and then output from the transceiver 700. Due to the presence of the TO-Can package 706, parasitic signal elements are eliminated, allowing fibre optic transceiver 700 to optimise operation. Furthermore, the fibre optic transceiver 700 is generally an element of a larger telecommunications network, and therefore the whole network can operate more efficiently. Advantageously, the present invention allows easy implementation because the additional capacitor can be attached either inside or outside an electronic package as illustrated by the embodiments of FIGS. 4, 5 and 6.

An electronic package modified in this way is compatible with any equipment that the electronic package was compatible with prior to modification. Also, the present invention is a very economical method of removing the difficulties presented by parasitic effects in electronic packages.

Whilst the invention has been described above in respect of several particular implementations of a TO-Can packaged laser diode, it will be appreciated that the present invention is applicable to any electronic packaged device suffering, or potentially suffering, from parasitic effects. Furthermore, it will be appreciated that the above description has been given by way of example only and that a person skilled in the art can make modifications and improvements without departing from the scope of the present invention.

## Claims

1. A high frequency electronic package comprising:
a metal housing;
at least one high frequency electronic device contained within the metal housing;
at least one lead passing into the metal housing and coupled to the at least one high frequency electronic component; and
a capacitance device coupled between the metal housing and the at least one lead for shorting stray capacitances to the at least one lead at high frequencies.

2. A high frequency electronic package according to claim 1, wherein the capacitance device is mounted in close proximity to the at least one lead.

3. A high frequency electronic package according to either claim 1 or claim 2, wherein the capacitance device is a high value capacitor.

4. A high frequency electronic package according to any preceding claim, wherein the at least one lead is an anode lead.

5. A high frequency electronic package according to any preceding claim, wherein the high frequency electronic device is a high power device.

6. A high frequency electronic package according to any preceding claim, wherein the capacitance device is mounted externally of the metal housing.

7. A high frequency electronic package according to any one of claims 1 to 5, wherein the capacitance device is mounted internally of the metal housing.

8. A high frequency electronic package according to claim 6, wherein the capacitance device is shaped so as to fit over the at least one lead and is mounted to a base of the housing.

9. A high frequency electronic package according to claim 7, wherein the capacitance device is a surface mounted component mounted on an external face of the housing.

10. A high frequency electronic package according to claim 7, wherein the capacitance device is a ceramic plate capacitor mounted on an internal face of the housing.

11. A high frequency electronic package according to any preceding claim, wherein the metal housing is a Thin Outline (TO) Can housing.

12. A high frequency electronic package according to any preceding claim, wherein the at least one high frequency electronic component is a laser diode.

13. A high frequency electronic package according to claim 12, further comprising means for coupling the laser diode to one or more optical fibres.

14. A high frequency electronic package according to claim 13, incorporated in a high frequency fibre optic transceiver.

15. A high frequency fibre optic transceiver incorporating the high frequency electronic package according to any one of claims 1 to 14.
